# EUROPEAN PATENT SPECIFICATION

(11) **EP 2 688 091 B1**
(45) Date of publication and mention of the grant of the patent: **16.03.2016**
(21) Application number: 12176910.3
(22) Date of filing: 18.07.2012
(51) Int. Cl.: H01L 21/302, H01L 21/306, B81C 1/00

(54) **Method for producing a cavity by anisotropically removing material from a substrate**
Verfahren zur Herstellung eines Hohlraums durch anisotropisches Entfernen von Material von einem Substrat
Procédé de production d'une cavité par l'élimination anisotrope d'un matériau provenant d'un substrat

(43) Date of publication of application: 22.01.2014
(73) Proprietor: IMEC, 3001 Leuven (BE)
(72) Inventor: Hantschel, Thomas, 3001 Leuven (BE); Vandervorst, Wilfried, 3001 Leuven (BE)
(74) Representative: Clerix, André

(56) References cited:
- EP-A1- 0 763 844
- WO-A2-01/32554
- GB-A- 939 841
- US-A- 5 366 925
- JIN S ET AL: "Thinning and patterning of CVD diamond films by diffusional reaction", DIAMOND AND RELATED MATERIALS, ELSEVIER SCIENCE PUBLISHERS, AMSTERDAM, NL, vol. 2, no. 5-7, 13 April 1993 (1993-04-13), pages 1038-1042, XP025442652, ISSN: 0925-9635, DOI: 10.1016/0925-9635(93)90270-C [retrieved on 1993-04-13]

## Description

### Field of the Invention

The present invention is related to the anisotropic formation of cavities in a substrate surface, such as pyramid-shaped molds or V-shaped and vertical trenches.

### State of the art.

Anisotropic Si etching is widely used in the area of micro- and nano-electromechanical systems (MEMS, NEMS) to produce a pre-defined shape into Si by selective Si removal using an anisotropic etchant. Typical anisotropic etchants are potassium hydroxide (KOH), sodium hydroxide (NaOH), and tetra-methyl ammonium hydroxide (TMAH) but also many others have been demonstrated such as ethylenediamine-pyrocatechol (EDP), hydrazine, cesium hydroxide (CsOH), ammonium hydroxide (NH₄OH) and lithium hydroxide (LiOH). The fundamental principle of anisotropic etching is that the etch rate is very different for different crystal planes. The shape which is defined into Si is depending on the orientation of the used Si wafer and the orientation of the hardmask opening. The typical [100]-oriented wafer gives inverted pyramids when a square (oriented parallel to the [110] direction) or a circular mask opening is used. In case of a rectangular mask opening (oriented parallel to the [110] direction), a V-shaped trench is formed.

The etched pits are often used directly for a device, e.g. a Si membrane used as part of a pressure sensor or a trench in Si is used as a liquid channel, or they can be used as molds where the etch pit is filled up with a material such as Si₃N₄, metal or diamond and the Si mold is finally removed by an etching step. In this way, pyramidal tips are created for use in scanning probe microscopy (SPM).

For example such a process for fabricating the micro-tip of a probe by using a mold obtained by KOH etching is disclosed in the document EP 0 763 844 A.

An important drawback of the most commonly used etchants KOH and NaOH is their non-compatibility with IC processing. Elaborate cleaning procedures are required. KOH is especially problematic as it is well know that Fenanoparticles from the KOH pellets do deposit onto the wafer and must be cleaned afterwards by diluted HCl. Another disadvantage of common anisotropic etching is that it is based on wet chemistry. The wafer has to be etched in a beaker or a wetbench. Due to the release of gaseous by-products such as H₂ during the etching, the wafer should be held under an angle to let the gas bubbles escape from the etched surface (otherwise these bubbles can passivate the surface which leads to hillocks and increased roughness). Moreover, the hardmask material is also considerably attacked during etching (e.g. for KOH the etch rate ratio between Si and SiO₂ is about 400). The hardmask material is often SiO₂ for small depths and Si₃N₄ for high depths. Although SiO₂ layers can be easily etched away afterwards by HF-based chemistry without affecting the etch pit, the low-pressure chemical vapor-deposited (LPCVD) Si₃N₄ can only be removed by 140°C hot H₃PO₄ etching or reactive ion etching (RIE), which affects the etch pit. Furthermore, the etch rate is relatively low, for example the etch rate of 30% KOH at 70°C is about 42 µm/h. It is to be noted also that commonly fresh etching solutions are used every time for obtaining smooth etched surfaces and hence chemical consumption is considerable and expensive.

The document US 5 366 925 discloses a process for forming isolation regions by filling cavities with insulating material. In this document, aluminium is deposited on silicon before annealing to form an alloy of aluminium and silicon. The alloy is removed to leave a cavity.

### Summary of the invention

The invention is related to a method forming a cavity in a substrate as disclosed in the appended claims, that overcomes the problems cited above. The method of the invention comprises the steps of:
- Providing a substrate comprising at least a top layer consisting of a crystalline material,
- Determining a desired shape and size of a cavity which is to be produced in said substrate,
- Determining on the basis of said desired shape and size the thickness and shape of a layer of a metal, wherein the crystalline material's dissolution rate into said metal is not the same for each crystallographic plane of said material's crystallographic structure,
- Producing a layer of said metal, said layer having said determined thickness and shape, on and in contact with at least one selected portion of the surface of said top layer,
- Heating the substrate at a temperature suitable for causing the dissolution of said crystalline material into said metal,
- cooling the substrate, thereby forming a volume of an alloy of the metal and the crystalline material,
- Removing said volume of said alloy, thereby obtaining a cavity of said desired shape and size in said substrate.
- depositing a filling material in said cavity, and
- separating the filling material and the substrate to obtain a structure formed of said filling material shaped by said cavity.

According to one embodiment, the step of producing a metal layer on at least one selected portion of the surface is done by:
- Producing a patterned mask layer on the surface of said top layer, thereby leaving one or more portions of said surface exposed,
- Depositing a metal layer on top of said mask layer, so that one or more portions of said metal layer are in direct contact with said one or more exposed surface portions.

According to another embodiment, the step of producing a metal layer on at least one selected portion of the surface is done by locally depositing said metal layer on said at least one selected portion.

In the invention as claimed, said crystalline material is crystalline silicon, and said metal is aluminium or an aluminium-based alloy. According to an embodiment, , an interface layer may be formed during the cooling step, between said volume and the material of the substrate, said interface layer consisting of Al-doped silicon. Further in the case of the Si/Al embodiment, the step of removing the alloy volume may be done by wet etching, wherein said interface layer acts as an etch stop layer during said wet etching step.

### Brief description of the figures

Figure 1 illustrates the steps of one embodiment of the method of the invention for forming a cavity in the shape of an inverted pyramid.
Figure 2 shows a 3D view of a pyramidal cavity obtainable by the method of the invention.
Figure 3 shows a 3D view of a rectangular-shaped cavity obtainable by the method of the invention.
Figure 4 illustrates the method according to another embodiment, wherein separate areas of aluminium are produced on a silicon substrate.
Figure 5 illustrates a variation of the embodiment of figure 4, wherein the Al areas are produced in pre-formed cavities in the silicon substrate.

### Detailed description of the invention

The invention is related to a method for producing cavities in a crystalline substrate or a substrate comprising a crystalline top layer, preferably a semiconductor substrate/top layer. The substrate can be a flat wafer or any other object with a surface that is suitable for performing on it the method steps of the invention. According to a preferred embodiment, a patterned hardmask is formed on the substrate, leaving one or more portions of the substrate exposed. Then a metal layer is deposited on top of the hardmask and on the exposed portions, and the substrate is heated so as to produce - in the exposed areas - an alloy of the substrate material and the added metal, through the dissolution of the substrate material into the metal. The choice of the substrate material and the metal in the method is such that the dissolution rate of the substrate material into the metal depends on the crystal plane of the crystallographic structure of the substrate. In this way, the alloy forms in a volume that is shaped along predefined crystallographic planes, for example an inverted pyramid or V-shaped trench. The preferred combination of materials is silicon for the substrate and aluminium as the deposited metal. The rest of this description is based on that preferred combination Si/Al, but the description is valid also for any other suitable combination (a suitable combination being defined as a substrate material and metal such that the dissolution rate of the substrate material into the metal depends on the crystal plane of the crystallographic structure of the substrate).

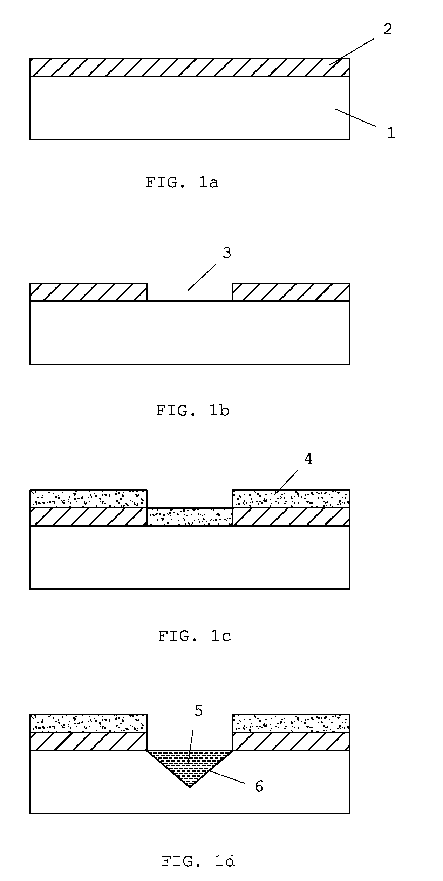

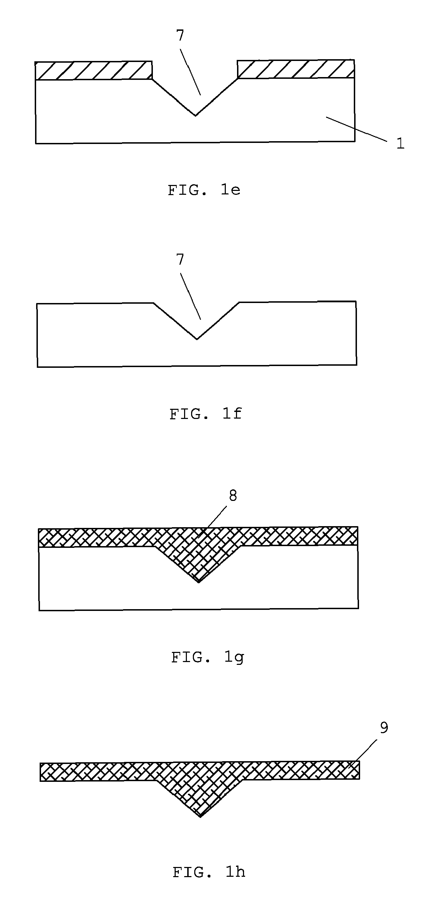

The dissolution rate of silicon in aluminium is lowest in the Si(111) plane due to the higher packing density in that plane. In this way, a pyramidal cavity can be produced by starting from a (100)-oriented silicon wafer, as illustrated in figure 1. Figure 1a illustrates a (100)Si substrate 1 provided with a hardmask 2, for example a silicon nitride or silicon oxide hardmask. The hardmask is locally opened by a lithography and etching step as known per se in the art (figure 1b), thereby forming an exposed area 3 of the Si-substrate. The hardmask opening has typically a square, rectangular, circular or oval shape for [100] and [110]-oriented Si wafers. For Si wafers with other orientations, other preferred hardmask opening shapes may be used, e.g. triangular for [311]-oriented wafers. Then an aluminium layer 4 is deposited, e.g. by sputtering or evaporation, onto the Si substrate and the hardmask, thereby forming an Al-layer 4' that is in direct contact with the exposed Si inside the hardmask opening 3 (figure 1c). The thickness of the deposited Al-layer is preferably between 100nm and 10µm. Then the substrate is annealed, preferably to a temperature higher than or equal to 800°C. During this anneal step, silicon dissolves into the aluminium layer 4', and a volume 5 of Si-Al alloy is formed in a pyramidal shape, due to the lower dissolution rate of Si in the (111)plane (figure 1d).

Then the substrate is cooled. During the cooling cycle, Si segregates out of the Si-Al alloy and epitaxially deposits onto the Si-to-Si/Al interface, thereby creating a highly Al-doped Si region 6. In the next step, the Si-Al alloy can be removed by a wet etching step (figure 1e), leaving a pyramidal cavity 7. The etchant used can be an HCl containing etchant. Depending on the type of etchant used, the Al-doped layer 6 may act as an etch stop layer, thereby protecting the Si-substrate underneath during the wet etching step. Alternatively, the Al-doped layer is removed together with the Si-Al alloy in one etch step. The Al-doped layer could also be removed in a separate etch step.

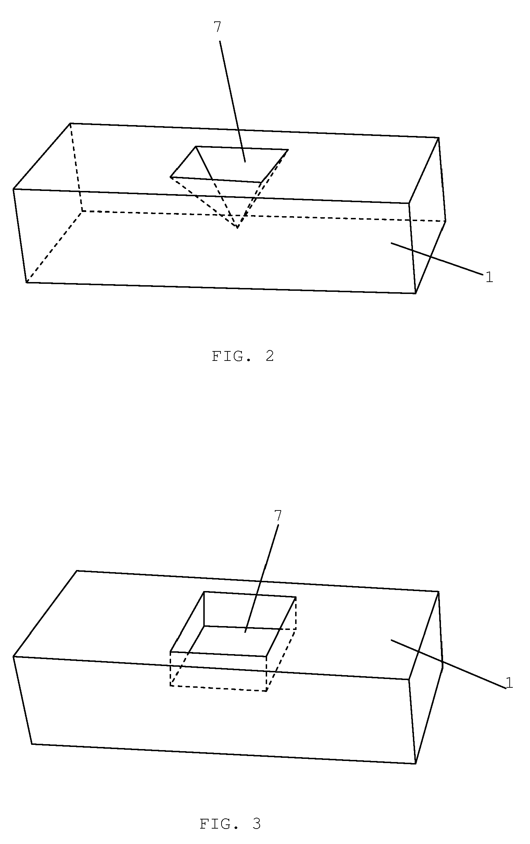

Following this, the hardmask is removed by a suitable etch technique known as such in the art (figure 1f), resulting in the substrate 1 being provided with the cavity 7 (illustrated in 3D view in figure 2). The shape and size of the cavity 7 is directly related to the thickness and the shape (i.e. the shape of the hardmask opening) of the aluminium layer 4'. In the method of the invention, the thickness and shape of the metal layer 4' are selected specifically on the basis of a desired cavity shape and size (e.g. a V-shaped trench with given dimensions).

The substrate provided with the cavity 7 is for example used as a mold for the production of a probe tip. Figure 1g illustrates the step of filling the mold with a suitable material 8, e.g. metal, diamond, oxide or nitride. Then the substrate 1 may be removed, resulting in the tip structure 9, forming at least part of a MEMS/NEMS device structure (e.g. scanning probe tip, field emission tip).

The method of the invention may be used to form other shapes of cavities, by adapting the shape of the exposed areas 3 and/or by starting from a substrate with a different crystallographic orientation. For example, instead of a pyramidal pit, a trench with vertical sidewalls may be formed starting from a (110)-oriented silicon wafer, as illustrated in figure 3. The obtained geometry of the cavity can be directly used as part of a MEMS/NEMS device. For example, long knife-shaped grooves can be used as alignment features for optical fibers or for chip alignment. An orifice through the Si substrate may be created (by extra polishing or etching from both sides). It should be pointed out that the present invention targets also wafer crystal orientations other than the common (100)-orientation leading to pyramidal structures. Examples are (110) substrates (as illustrated in figure 3) and (311)-cut wafers. Other orientations might be used as well.

As stated, the thickness of the aluminium layer deposited on the exposed Si area 3 is used to control the shape of the formed cavity. In the case of figure 1, less aluminium may be deposited than would be required for forming an inverted pyramid with a sharp tip. The result is the formation of a truncated pyramid. By a separate patterning step, the aluminium layer 4' on the exposed area 3 may be brought into a specific shape, which will have an additional influence on the final shape of the cavity. This is a capability that is not available in the classic anisotropic wet etching methods.

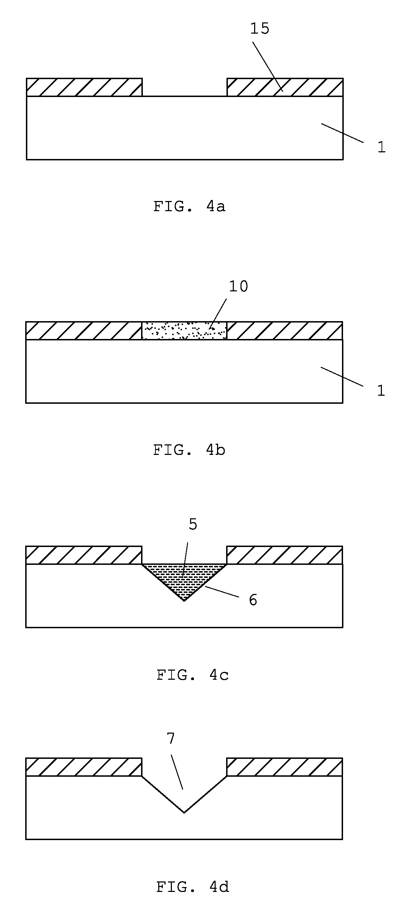

As an alternative to the embodiment of figure 1, it is possible to produce separate layers 10 of aluminium locally on the Si-substrate, instead of depositing a layer of aluminium over a patterned mask layer. This embodiment is illustrated in figures 4a to 4d. In this embodiment, a patterned hardmask 15 is preferably deposited on the substrate before producing the separate layers 10 in the openings of the hardmask (Figures 4a and 4b). The layer 10 can be produced by a standard lithography and etching step (deposition of Al-layer and resist layer, patterning the resist, etching Al so that Al remains only in desired areas, removing resist). On the substrate as shown in figure 4b, the same steps of annealing, cooling and etching for removal of the alloy are performed as described with respect to figure 1, resulting in the same type of cavity 7 (as shown in figures 4c and 4d). In this embodiment, the hardmask 15 (although preferred in order to laterally contain the Si-Al during formation of the alloy) is not required during the formation of the cavity, which is equally a capability not available in the prior art methods, where the hardmask is necessary to protect the areas outside the zones where the cavities are to be formed. When several of such Al-layers 10 are produced separately in the manner shown in figure 4, these layers could be deposited in different thicknesses, which provides an additional means of controlling the shape and size of the formed cavity.

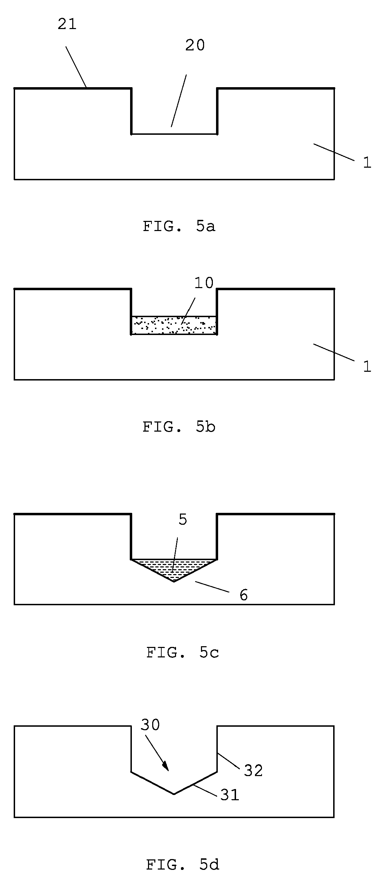

In a variation of this embodiment, the locally produced Al-layers 10 may be produced in pre-formed cavities in the substrate surface, as shown in figure 5a to 5c. The cavity 20 can be formed by a standard lithography and etching technique. In this embodiment also, it is preferable to produce a patterned hardmask 21 on the top surface of the substrate 1 and on the vertical side walls of the pre-formed cavity 20, before producing the Al-layer 10 in the openings of the hardmask, i.e. at the bottom of the cavity 20. Then the Al-layer 10 is produced also by standard lithography as in the embodiment of figure 4. Then the same steps as described above are performed: annealing, cooling, etching to remove the alloy. The final cavity 30 that is formed has a pyramidal portion 31 and a portion 32 with vertical side walls. Contrary to the example shown in figure 5, the pre-formed cavity 20 could be larger (as seen from above) than the pyramidal cavity 31 formed by the Al-Si alloy, thus resulting in a cavity with a larger portion with vertical side-walls and a smaller portion formed by the Al-Si alloy, for example in the middle of the larger cavity portion.

In all of the embodiments described above, instead of pure aluminium, the metal layer 4 or 10 may be an Al-based alloy, e.g. Al with boron.

## Claims

1. A method for forming a cavity in a substrate, said method comprising the steps of :
- providing a substrate (1) comprising at least a top layer consisting of a crystalline material, the material being silicon,
- determining a desired shape and size of a cavity (7) which is to be produced in said substrate,
- determining on the basis of said desired shape and size the thickness and shape of a layer (4,10) of a metal, the metal being aluminium or an aluminium-based alloy, wherein the crystalline material's dissolution rate into said metal is not the same for each crystallographic plane of said material's crystallographic structure,
- producing a layer (4,10) of said metal, said layer having said determined thickness and shape, on and in contact with at least one selected portion (3) of the surface of said top layer,
- heating the substrate (1) at a temperature suitable for causing the dissolution of said crystalline material into said metal,
- cooling the substrate, thereby forming a volume (5) of an alloy of the metal and the crystalline material,
- removing said volume of said alloy, thereby obtaining a cavity (7) of said desired shape and size in said substrate,
further comprising the steps of :
- depositing a filling material (8) at least in said cavity (7), and;
- separating the filling material (8) and the substrate (1), to thereby obtain a structure (9) formed of said filling material and shaped by said cavity.

2. The method according to claim 1, wherein the step of producing a metal layer on at least one selected portion of the surface is done by :
- producing a patterned mask layer (2) on the surface of said top layer, thereby leaving one or more portions (3) of said surface exposed,
- depositing a metal layer (4) on top of said mask layer, so that one or more portions (4') of said metal layer are in direct contact with said one or more exposed surface portions (3).

3. The method according to claim 1, wherein the step of producing a metal layer on at least one selected portion (3) of the surface is done by locally depositing said metal layer (10) on said at least one selected portion.

4. The method according to claim 1, wherein during the cooling step, an interface layer (6) is formed between said volume and the material of the substrate, said interface layer consisting of Al-doped silicon.

5. The method according to claim 4, wherein the step of removing the alloy volume (5) is done by wet etching, and wherein said interface layer (6) acts as an etch stop layer during said wet etching step.

## Patentansprüche

1. Verfahren zur Bildung einer Ausnehmung in einem Substrat, wobei das genannte Verfahren die folgenden Stufen umfasst:
- Bereitstellen eines Substrats (1), das wenigstens eine obere Schicht umfasst, die aus einem kristallinen Material besteht, wobei das Material Silikon ist,
- Bestimmen einer gewünschten Form und Größe einer Ausnehmung (7), die in dem genannten Substrat zu produzieren ist,
- auf der Basis der genannten gewünschten Form und Größe Bestimmung der Dicke und Form einer Schicht (4, 10) eines Metalls, wobei das Metall Aluminium oder eine Legierung auf Aluminiumbasis ist, wobei die Auflösungsrate des kristallinen Material in das genannte Metall nicht für jede kristallographische Ebene der genannten kristallographischen Struktur des genannten Material dieselbe ist,
- Produzieren einer Schicht (4, 10) des genannten Metalls, wobei die genannte Schicht die genannte bestimmte Dicke und Form auf und in Kontakt mit wenigstens einem ausgewählten Abschnitt (3) der Fläche der genannten oberen Schicht hat,
- Erhitzen des Substrats (1) auf eine Temperatur, die für die Veranlassung der Auflösung des genannten kristallinen Materials in das genannte Metall geeignet ist,
- Kühlen des Substrats, wodurch ein Volumen (5) einer Legierung des Metalls und des kristallinen Material gebildet wird,
- Entfernen des genannten Volumens der genannten Legierung, wodurch eine Ausnehmung (7) der genannten gewünschten Form und Größe in dem genannten Substrat erhalten wird,
weiterhin umfassend die Schritte:
- Aufbringen eines Füllmaterials (8) wenigstens in der genannten Ausnehmung (7), und;
- Trennen des Füllmaterials (8) und des Substrats (1), um dadurch eine Struktur (9) zu erhalten, die aus dem genannten Füllmaterial gebildet und durch die genannte Ausnehmung geformt wird.

2. Verfahren gemäß Anspruch 1, bei dem die Stufe der Produktion einer Metallschicht auf wenigstens einem ausgewählten Abschnitt der Oberfläche durch:
- Produzieren einer gemusterten Maskenschicht (2) auf der Oberfläche der genannten oberen Schicht, wodurch ein oder mehrere Abschnitte (3) der genannten Fläche exponiert wird / werden,
- Aufbringen einer Metallschicht (4) auf der Oberseite der genannten Maskenschicht derart erfolgt, dass sich ein oder mehrere Abschnitt(e) (4') der genannten Metallschicht in direktem Kontakt mit dem genannten einen oder den genannten mehreren exponierten Oberflächenabschnitt(en) befinden.

3. Verfahren gemäß Anspruch 1, bei dem die Stufe der Produktion einer Metallschicht auf wenigstens einem ausgewählten Abschnitt (3) der Oberfläche durch lokales Aufbringen der genannten Metallschicht (10) auf dem genannten wenigstens einen ausgewählten Abschnitt erfolgt.

4. Verfahren gemäß Anspruch 1, bei dem während der Kühlstufe eine Schnittstellenschicht (6) zwischen dem genannten Volumen und dem Material des Substrats gebildet ist, wobei die genannte Schnittstellenschicht aus Al-gedoptem Silikon besteht.

5. Verfahren gemäß Anspruch 4, bei dem die Stufe der Entfernung des Legierungsvolumens (5) durch Feuchtätzen erfolgt und bei dem die genannte Schnittstellenschicht (6) als eine Ätzstoppschicht während der genannten Feuchtätzstufe wirkt.

## Revendications

1. Procédé pour former une cavité dans un substrat, ledit procédé comprenant les étapes de :
- fourniture d'un substrat (1) comprenant au moins une couche supérieure consistant en une matière cristalline, la matière étant du silicium,
- détermination d'une forme et d'une taille souhaitées d'une cavité (7) qui doit être produite dans ledit substrat,
- détermination sur la base desdites forme et taille souhaitées de l'épaisseur et de la forme d'une couche (4, 10) d'un métal, le métal étant de l'aluminium ou un alliage à base d'aluminium, dans lequel la vitesse de dissolution de la matière cristalline dans ledit métal n'est pas la même pour chaque plan cristallographique de la structure cristallographique de ladite matière,
- production d'une couche (4, 10) dudit métal, ladite couche ayant lesdites épaisseur et forme déterminées, sur et en contact avec au moins une partie sélectionnée (3) de la surface de ladite couche supérieure,
- chauffage du substrat (1) à une température appropriée pour provoquer la dissolution de ladite matière cristalline dans ledit métal,
- refroidissement du substrat, formant de ce fait un volume (5) d'un alliage du métal et de la matière cristalline,
- enlèvement dudit volume dudit alliage, obtenant de ce fait une cavité (7) desdites forme et taille souhaitées dans ledit substrat,
comprenant en outre les étapes de :
- dépôt d'une matière de remplissage (8) au moins dans ladite cavité (7) ; et
- séparation de la matière de remplissage (8) et du substrat (1), pour obtenir de ce fait une structure (9) formée de ladite matière de remplissage et mise en forme par ladite cavité.

2. Procédé selon la revendication 1, dans lequel l'étape de production d'une couche de métal sur au moins une partie sélectionnée de la surface est faite par :
- la production d'une couche de masque à motifs (2) sur la surface de ladite couche supérieure, laissant de ce fait une ou plusieurs parties (3) de ladite surface exposées,
- le dépôt d'une couche de métal (4) sur le dessus de ladite couche de masque, de sorte qu'une ou plusieurs parties (4') de ladite couche de métal sont en contact direct avec lesdites une ou plusieurs parties de surface exposées (3).

3. Procédé selon la revendication 1, dans lequel l'étape de production d'une couche de métal sur au moins une partie sélectionnée (3) de la surface est faite en déposant localement ladite couche de métal (10) sur ladite au moins une partie sélectionnée.

4. Procédé selon la revendication 1, dans lequel pendant l'étape de refroidissement, une couche d'interface (6) est formée entre ledit volume et la matière du substrat, ladite couche d'interface consistant en silicium dopé à l'Al.

5. Procédé selon la revendication 4, dans lequel l'étape d'enlèvement du volume d'alliage (5) est faite par attaque humide, et dans lequel ladite couche d'interface (6) agit comme une couche d'arrêt d'attaque pendant ladite étape d'attaque humide.
